# EUROPÄISCHE PATENTSCHRIFT

(11) **EP 0 706 749 B1**
(45) Veröffentlichungstag und Bekanntmachung des Hinweises auf die Patenterteilung: **23.04.1997**
(21) Anmeldenummer: 94920457.2
(22) Anmeldetag: 22.06.1994
(51) Int. Cl.: H05K 13/04

(54) **VERFAHREN UND VORRICHTUNG ZUR REPARATUR VON ELEKTRONIKPLATINEN**
PROCESS AND DEVICE FOR REPAIRING ELECTRONIC BOARDS
PROCEDE ET DISPOSITIF DE REPARATION DE PLATINES ELECTRONIQUES

(30) Priorität: 22.06.1993 DE 4320670
(43) Veröffentlichungstag der Anmeldung: 17.04.1996
(73) Patentinhaber: MICROTRONIC Microelectronic Vertriebs GmbH, D-84494 Neumarkt-Sankt Veit (DE)
(72) Erfinder: EGGELAAR, Josef, A., D-84494 Neumarkt-Sankt Veit (DE)
(74) Vertreter: Kirschner, Klaus Dieter, Dipl.-Phys.
(86) Internationale Anmeldenummer: EP9402041
(87) Internationale Veröffentlichungsnummer: WO9501089

(56) Entgegenhaltungen:
- EP-A- 0 097 796
- GB-A- 2 050 906

## Beschreibung

Die Erfindung betrifft ein Verfahren und eine Vorrichtung zur reparaturmäßigen Entfernung elektronischer Bauelemente von einem Platinensubstrat, insbesondere von integrierten Schaltkreisen, die mit einem Haftmittel auf einem Platinensubstrat angebracht sind, siehe z.B. GB-A-2 050 906.

Elektronische Regelungs- und Steuerungssysteme auf der Basis hochintegrierter elektronischer Schaltkreise werden nahezu in allen Anwendungsbereichen benötigt, in denen komplexe Arbeits- und Herstellungsgeräte, Meßgeräte, Transportmittel, Gebrauchsgegenstände und dgl. verwendet werden. Dabei ist die Zuverlässigkeit und Funktionssicherheit, insbesondere von Regelungs- und Steuereinrichtungen entscheidend für die Gesamtfunktion des betreffenden Gerätes, so daß entsprechende, mit integrierten Schaltkreisen bestückte Platinen regelmäßig vor ihrem bestimmungsgemäßen Einbau in einem Prüffeld sorgfältig getestet und im Falle von Fehlern ausgesondert werden. Das Problem der Prüfung von Regelungs- und Steuereinrichtungen spielt insbesondere bei Anwendungen mit hohen Anforderungen an die Funktionssicherheit und Zuverlässigkeit wie z. B. im Automobilbau bei der Steuerung von "Airbag"-Sicherheitssystemen und ähnlichem - eine wichtige Rolle.

Ein Platinensubstrat besteht aus Kunststoff oder Keramik und ist üblicherweise mit einer Vielzahl von integrierten Schaltkreisen und Einzelbauelementen bestückt, die mit aufgedruckten Leiterbahnen funktionsgerecht verschaltet sind. Dabei können die Schaltkreise aufgelötet oder mit einem geeigneten Klebstoff aufgeklebt sein.

Erfahrungsgemäß ergibt sich bei einem negativen Platinentestergebnis, daß lediglich eines der auf dem Platinensubstrat angebrachten Bauelemente defekt ist, und daher dennoch die gesamte Platine ausgesondert werden muß. Da jedoch die vorhergehende Platinenherstellung bereits verhältnismäßig hohe Kosten verursacht hat, zu denen insbesondere auch der Einsatz technologisch wichtiger, teurer Materialen beiträgt, besteht ein starkes Interesse daran, nach Aussonderung einer Platine im Prüffeld diese nicht als Ausschuß zu verschrotten, sondern nach Ersatz des defekten Bauelements einer erneuten Prüfung und dem bestimmungsgemäßen Einsatz zuzuführen.

Der Ersatz von integrierten Schaltkreisen, die auf Platinensubstraten befestigt und elektrisch mit dem entsprechenden Leitungsmuster verbunden sind, bereitet erhebliche Schwierigkeiten, da die Entfernung des defekten Bauelements den Einsatz mechanischer Kräfte erfordert, deren Maß und Wirkungsrichtung durch die Bestückungsdichte der Substratplatine und die Empfindlichkeit der benachbarten, funktionstüchtigen Schaltkreise eingeschränkt wird. Außerdem werden elektronische Schaltkreise üblicherweise auf dem Platinensubstrat mit einem Epoxydharz-Kleber befestigt, der zur Erzielung einer leitfähigen Verbindung z. B. mit einem unter dem Schaltkreis angeordneten Massekontakt mit Silberpartikeln versehen ist. Derartige Epoxydharz-Klebstoffe stellen entsprechend den Sicherheitsanforderungen eine sehr feste Verbindung mit dem Substrat bereit, die das Problem der Schaltkreisentferung mit mechanischen Mitteln weiter erschweren.

Bei einem bekannten Verfahren zum reparaturmäßigen Ersatz insbesondere von integrierten Schaltkreisen von Platinen wird die Platine mit dem defekten Bauelement auf einem Arbeitstisch unter einem induktiv geheizten Stempel ausgerichtet, der manuell ähnlich zur Werkzeugführung einer Standbohrmaschine auf das Bauelement aufgesetzt wird und dieses aufheizt. Anschließend wird das Bauelement ebenfalls manuell mit einem Handwerkzeug oder einem geeigneten Abscherwerkzeug entfernt. Dieses bisher ausgeübte Verfahren besitzt den Nachteil, daß beim Aufheizen und bei der mechanischen Entfernung wegen der individuellen Arbeitsweise des Bedieners keine definierten Betriebsparameter eingehalten werden, wodurch die Gefahr besteht, daß z. B. die Umgebung des betreffenden Bauelements überheizt und beschädigt wird oder daß bei zu geringer Heizung des Bauelementes zu starke mechanische Kräfte zur erfolgreichen Schaltkreisentfernung eingesetzt werden müssen, die wiederum die übrigen Bauelemente gefährden. Außerdem besteht bei der manuellen Positionierung des Arbeitstisches mit der Platine die Gefahr, daß das betreffende Werkzeug mit dem betreffenden Bauteil keinen genügend kraftschlüssigen Eingriff erhält und bei Kraftaufwendung abgleitet oder unter Bruchbildung lediglich einen Teil des Schaltkreises entfernt, wobei im letzteren Fall die Schwierigkeiten zur Entfernung der verbliebenen Reste weiter erhöht werden. Aufgrund dieser Probleme ist die o. g. Erfahrung, daß der Ersatz einzelner Bauelemente billiger ist als die Neuherstellung der Gesamtplatine bisher in der Praxis kaum wirksam umgesetzt worden, da das oben genannte Verfahren durch seinen großen Zeitaufwand bei verhältnismäßig geringer Erfolgsquote seinerseits hohe Kosten verursacht.

Ein weiterer Nachteil des bekannten Verfahrens besteht darin, daß bei der manuellen Bauelementeentfernung sämtliche anfallenden Bauelemente mit den gleichen Werkzeugen entfernt werden, d. h. daß keine Anpassung des Werkzeugs an die Form des zu entfernenden Bauelementes erfolgt bzw. die Einrichtung einer Vielzahl verschiedener Werkzeuge vorzusehen ist, an denen jeweils die verschiedenen Bauelemente entfernt werden können.

Gegenüber den oben diskutierten Problemen liegt der vorliegenden Erfindung die Aufgabe zugrunde, ein Verfahren und eine Vorrichtung zur reparaturmäßigen Entfernung elektronischer Bauelemente von einem Platinensubstrat, insbesondere integrierter Schaltkreise, die mit einem Haftmittel auf einem Platinensubstrat angebracht sind, anzugeben, womit eine sichere Bauelemente-Entfernung unter reproduzierbaren Bedingungen für verschiedene Bauelemente-Typen mit hoher Wirksamkeit ermöglicht wird.

Diese Aufgabe wird durch ein Verfahren und eine Vorrichtung mit den in den unabhängigen Patentansprüchen 1 und 13 enthaltenen Merkmalen gelöst. Vorteilhafte Ausführungsformen der vorliegenden Erfindung ergeben sich aus den Unteransprüchen.

Ausführungsbeispiele der vorliegenden Erfindung werden im folgenden anhand der beigefügten Figuren beschrieben. Es zeigen:
- Fig. 1: eine Übersichtsdarstellung einer halbautomatischen Bauelemente-Entfernungseinrichtung, die mit einer erfindungsgemäßen Vorrichtung versehen ist,
- Fig.2: eine schematische Seitenansicht einer Eingangs-Rasterplatte,
- Fig.3: eine Vorderansicht eines Heiz- und Scherkopfes, mit dem die erfindungsgemäße Vorrichtung versehen ist,
- Fig.4: eine Draufsicht auf ein in der erfindungsgemäßen Vorrichtung vorgesehenes Heizkreuzes in teilweise zerlegter Darstellung, und
- Fig. 5: eine Darstellung zur Illustration des Heizstempelwechsels in der erfindungsgemäßen Vorrichtung.

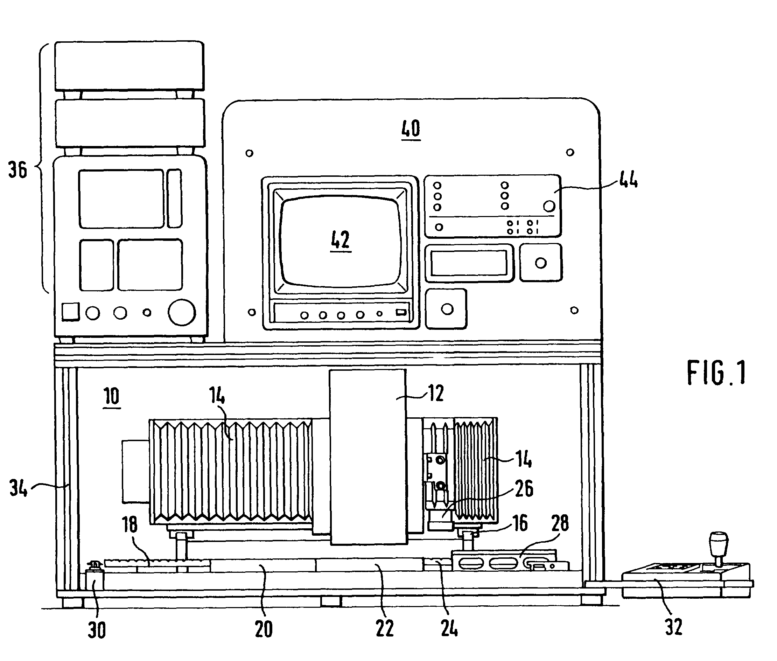

In Fig. 1 ist schematisch die Vorderansicht einer Anlage dargestellt, die erfindungsgemäß zur Platinenreparatur z. B. in einem Prüffeld eingesetzt werden kann. Kernstück der Anlage ist der Operationsbereich 10, der den Heiz- und Scherkopf 12 (hier mit einer Haube verdeckt), die X- bzw. Y-Vortriebseinheiten 14 bzw. 16, die Kamera 26, diverse Arbeitstische (18, 20, 22, 24), einen Handwagen 28 und Bedienelemente 30, 32 umfaßt, die in einem Rahmen 34 angeordnet sind. Die Arbeitstische umfassen im einzelnen die Eingangs-Rasterplatte 18, den Vorheiztisch 20, den Arbeitstisch 22 und die Ausgangs-Rasterplatte 24. Die Funktion der Bestandteile des Operationsbereiches 10 wird weiter unten im einzelnen beschrieben.

Weiterhin umfaßt die in Fig. 1 gezeigte Gesamtanlage Regelgeräte 36 für den Vorheiz- und den Arbeitstisch 20, 22 und für die Heizmittel im Heiz- und Scherkopf 12. Die Steuereinheit 40 enthält in ihrer dem Bediener zugewandten Frontplatte einen Monitor 42 zur optischen Überwachung der Platinenausrichtung und ein Bedienfeld 44. Auf dem Monitor 42 wird während des entsprechenden Verfahrenschrittes die Ausrichtung des defekten Bauelements auf der Platine unter der Positionierungskamera 26 beobachtet und das jeweils angewählte Werkzeug angezeigt.

Sämtliche beweglichen Komponenten werden mit Hilfe von Wegbegrenzungssensoren (Mikroschalter) überwacht, wobei im Falle von Fehlbewegungen ein Not-Stop ausgelöst werden kann. Die übrige Bedienung erfolgt durch den Startknopf 30 und das Bedienpult 32, das insbesondere einen Joystick zur Positionierung der Kamera über dem Substrat enthält.

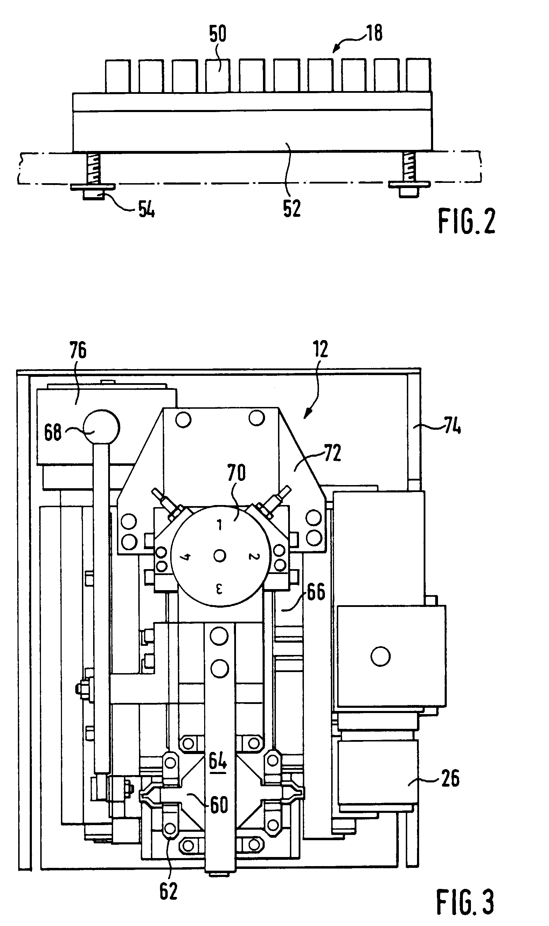

In Fig. 2 ist beispielhaft der Querschnitt der Eingangs-Rasterplatte 18 dargestellt, die eine Rastertafel 50 umfaßt, welche mit Zylinderschrauben 54 an der Montageleiste 52 und dem Rahmen 34 angebracht ist.

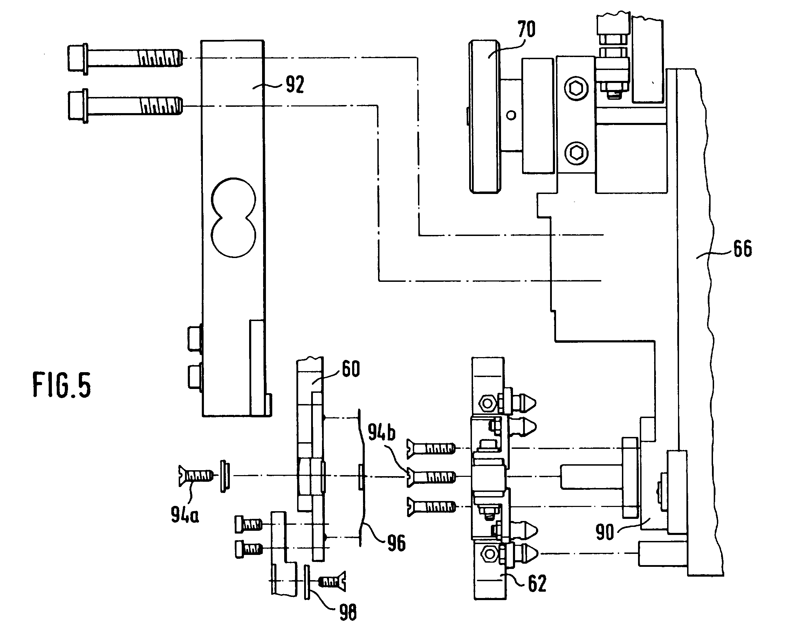

Die in Fig. 3 dargestellte Werkzeugeinheit mit dem Heiz- und Scherkopf 12 und der Kamera 26 bildet das Kernstück der Gesamtanlage. Sie umfaßt die Heiz-Scher-Einheit, die durch das Scherkreuz 60 und das Heizkreuz 62 gebildet wird, welche an dem (verdeckten) Werkzeugkopf (Werkzeugkopf 30, s. Fig. 5) angebracht sind, die Kamera 26, einen Führungsschlitten 72 zur Bewegung der Werkzeugeinheit auf der Z-Fahreinheit 66, Werkzeugauswahlmittel, die das Handrad 70 und den Einrasthebel 68 umfassen, und weitere Antriebselemente 76, wobei der Rahmen 74 den Heiz- und Scherkopf umgreift. Die Funktion der Werkzeugeinheit gemäß Fig. 3 wird unten beschrieben.

Die Heiz-Scher-Einheit besteht aus einem Drehkreuz mit vier Heizstempeln verschiedener Größe und den dazu passenden Schermeißeln. Der jeweils gewünschte Heizstempel mit dem dazugehörigen Schermeißel kann mittels des oben montierten Handrades 70 angewählt werden, wobei vor dem Wechsel mit dem Einrasthebel 68 die Verdrehsicherheit des Drehkreuzes aufgehoben werden muß.

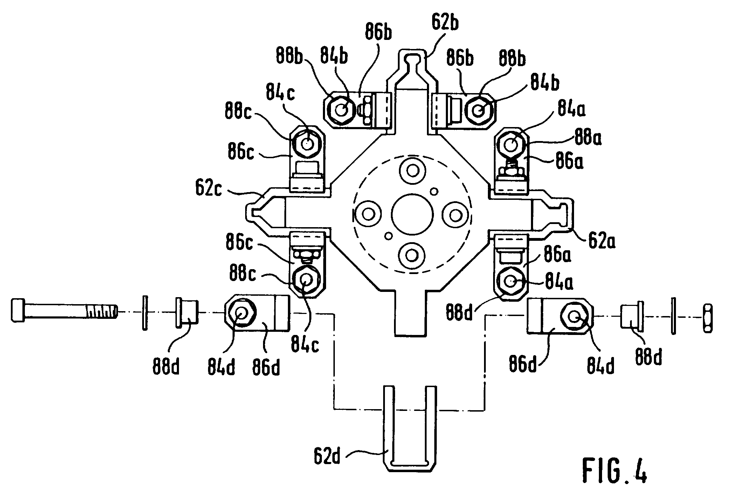

In Fig. 4 ist das Heizmittel 62 der Heiz-Scher-Einheit in teilweise zerlegter Darstellung gezeigt. Das Heizmittel 62 wird durch ein Heizkreuz gebildet, das vier Heizstempel 62a - 62d enthält, die jeweils entsprechend über zwei seitliche Kontakte 80a-80d mit einer Stromversorgung verbunden sind. Die Stempelbeheizung wird durch eine Impulsheizung gebildet. Die Impulsheizung erfolgt unter einer Stromaufnahme von rund 200-500 A, weshalb die Kontaktstifte und -bleche 84a-d, 86a-86d massiv ausgeführt sind. Isolationselemente 88a, 88d isolieren die Stromversorgung von dem übrigen Heizkreuz 62. Die Heizstempeltemperatur wird mit einem Thermoelement gemessen, das mit federnden Stiften vorgespannt in dem nicht gezeigten, rückseitigen Kontaktwagen eingelassen ist.

An das Heizkreuz 62 angrenzend ist das Scherkreuz 60 montiert. Beide Kreuze sind mit Heizstempeln verschiedener Größe bzw. den dazu passenden Schermeißeln verschiedener Größe versehen, wobei der Wechsel der jeweiligen Stempel-Meißel-Einheit durch das Handrad 70 erfolgt, nachdem der Kontaktwagen mit der Stromzuführung und dem Thermoelement mit dem Einrasthebel 68 nach hinten geschoben und damit die Werkzeugeinheit freigegeben wurde.

Im folgenden wird der Betriebsablauf entsprechend dem erfindungsgemäßen Verfahren zur reparaturmäßigen Entfernung von Bauelementen von einem Platinensubstrat beschrieben:

Die in Fig. 1 gestellte Gesamtanlage wird als Halbautomat betrieben. Die zu bearbeitenden Substrate werden manuell an der Eingangs-Rasterplatte 18 eingelegt, die mit der Rastereinteilung 50 (siehe Fig. 2) versehen ist, welche der Stegteilung des Substratmagazins entspricht. Auf dem Vorheiztisch 20 wird das gesamte Platinensubstrat auf eine Temperatur von rd. 80°C vorgeheizt, um eine schrittweise Erwärmung auch der Umgebung des zu entfernenden Schaltkreises zu ermöglichen. Diese Platinentemperierung ist notwendig, da die Platine eine Vielzahl von Bauelementen und Leitermaterialen trägt, welche sich durch unterschiedliche thermische Ausdehnungskoeffizienten auszeichnen, so daß ein schnelles und ungleichmäßiges Erhitzen zum Platinenbruch führen könnte. Das Vorheizen wird mit den Regelgeräten 36 geregelt, die die jeweils aktuelle Tischtemperatur anzeigen.

Dementsprechend wird anschließend die Platine auf dem Arbeitstisch 22 weiter auf nunmehr 150° C aufgeheizt. Dabei wird das Substrat auf einer Bohrung in dem Arbeitstisch 20 plaziert, die durch einen Vakuumsensor überwacht wird. Sobald dem Rechner in der Steuereinheit 40 das Anliegen eines Substrates gemeldet wird, beginnt eine Zeitmessung, wobei nach Überschreitung einer bestimmten Zeit ein akustisches und optisches Signal abgegeben wird, das vor einer übermäßigen Erhitzung der Platine warnt. Die Vorheiztemperatur auf dem Vorheiztisch 20 und dem Arbeitstisch 22 wird mit den Regelgeräten 36 eingestellt und nachgeregelt. An beiden Heiztischen ist in Y-Richtung (nach hinten) eine Anschlagleiste angebracht, an die das Platinensubstrat angelegt wird.

Nach Positionierung der Kamera 26 über dem zu entfernenden Bauelement, so daß dieses in einem definierten Meßfeld erscheint, wird automatisch die Bauelementposition durch den Rechner in der Steuereinheit erfaßt. Die Positionierung erfolgt durch den Bediener, der unter Verwendung des Joysticks auf dem Bedienpult 32 mit den X- und Y-Vortriebseinheiten 14, 16 die Kamera so über die Platine lenkt, daß das betreffende Bauelement in einem Meßfenster auf dem Monitor 42 erscheint, wobei die Fensterunterkante mit der Schaltkreiskante, an der der Schermeißel ansetzt, übereinstimmt.

Danach wird der von den X- und Y-Vortriebseinheiten 14, 16 angetriebene Heiz- und Scherkopf rechnergesteuert über das defekte Bauelement geführt. Der Antrieb der Vortriebseinheiten 14, 16 erfolgt über Schrittmotoren (Scheibenläufer) mit Riemenbetrieb auf einem Rollengewindegetriebe. Dabei bestehen die Längsführungen aus Profilschienen mit Kugelumlaufwagen. Die Auflösung der Positionierung des Heiz- und Scherkopfes 12 beträgt mindestens 1 µm. Anschließend wird die Werkzeugeinheit mit der ausgewählten Heizstempel-Schermeißel-Kombination mit der Z-Fahreinheit 66, (siehe Fig. 3) auf das defekte Bauelement aufgesetzt. Die Z-Fahreinheit 66 wird durch eine Doppellinear-Führung gebildet, die aus einer Hauptschiene und einer Endführung besteht. Mit einem Z-Kraftmeßsensor mit Dehn-Meßstreifen (sog. DMS) wird die Aufsatzkraft des Heizstempels auf dem Bauelement gemessen und entsprechend das Aufsetzen geregelt. Die Aufsetzkraft bestimmt die Wärmeübertragung von dem Heizstempel auf den zu entfernenden Schaltkreis, wobei es darauf ankommt, die gesamte Chip-Fläche zu erwärmen.

Der auf dem Schaltkreis aufsitzende Heizstempel wird mit einer Impulsheizung 270° C für die Dauer von 3 s erwärmt. Diese Zeit ist erfahrungsgemäß notwendig, um das Klebemittel, mit dem der Schaltkreis an der Platine befestigt ist, zu erweichen, um ein nachträgliches Abscheren zu ermöglichen, ohne jedoch das übrige Substrat thermisch zu beschädigen. Unmittelbar nach der Heizphase wird von dem Heiz- und Scherkopf 12 automatisch der gleichzeitig mit dem Heizstempel angesetzte Schermeißel an das Bauelement betätigt. Der Schermeißel ist mit einem Y-Kraftmeßsensor (DMS) versehen, so daß die Scherkraft in definierter Weise ausgeübt werden kann. Der Schermeißel drückt mit einer maximalen Scherkraft von rd. 650 N gegen die Schaltkreiskante, wobei dieser Vorzugswert ein Optimum dahingegehend darstellt, daß einerseits die Klebeverbindung zum Substrat überwunden wird, andererseits jedoch Schaltkreisteile oder die gesamte Platine vor Bruch geschützt wird. Die Scherkraft wird während der Meißeelbewegung in Y-Richtung ständig gemessen. Sobald der Y-DMS ein abruptes Nachlassen der Scherkraft feststellt oder falls die Verschiebung in Y-Richtung 1 mm beträgt, wird die Kraftausübung abgebrochen, da dann der Schaltkreis entweder erfolgreich abgelöst wurde oder andernfalls die eingestellten Parameter zur Bauelemente-Ablösung vor einem erneuten Abschervorgang korrigiert werden müssen.

Der oben beschriebene Verfahrensablauf kann menügeführt erfolgen.

Die Werkzeugeinheit mit den Heizstempeln und den Schermeißeln ist an dem Werkzeugkopf schwimmend gelagert, so daß, falls der zu entfernende Chip schräg auf der Platine sitzt, die Werkzeuge sich an diese Lage anpassen können und somit die Kraftübertragung optimiert wird.

Nach dem erfolgreichen Abschervorgang wird das Substrat von dem Arbeitstisch abgehoben. Dazu dient der Handwagen mit Kühlluftspülung, dessen Verfahrenssweg von dem Vorheiztisch 20 bis zu seiner in Fig. 1 dargestellten rechtsseitigen Einraststellung reicht. In der Einraststellung wird automatisch Kühlluft unter die Glasplatte des Handwagens geleitet, deren Dosierung über ein (nicht gezeigtes) Drosselventil erfolgt.

Ein Vorteil des erfindungsgemäßen Abscherverfahrens besteht darin, daß ein Großteil des Klebemittels gemeinsam mit dem Schaltkreis entfernt wird, wobei lediglich geringfügige Ränder bestehen bleiben, die manuell nachgearbeitet werden müssen. Ebenso sind gegebenenfalls Reste von Bond-Drähten zu entfernen. Sollte der entfernte Chip am Heizstempel anhaften, so kann er von einer gesonderten, nicht dargestellten Bürste abgehoben werden. Die Reinigungsbürste dient außerdem der Reinigung der Heizstempel und der Schermeißel von Kleberückständen, was z.B. durch eine exzenterbetriebene Edelstahlbürste durchgeführt werden kann.

Nach dem Abscheren und der Reinigung fährt der Heiz- und Scherkopf in eine Parkposition, in der mittels eines (nicht gezeigten) Spiegels die Betriebsbereitschaft für weitere Abschervorgänge kontrolliert werden kann. Nach Durchführung des erfindungsgemäßen Verfahrens zur Schaltkreisentfernung wird das Substrat manuell nachgearbeitet.

Die Fig. 5 stellt (teilweise auseinandergezogen) eine Seitenansicht der Heiz-Scher-Einheit an dem Heiz- und Scherkopf 12 dar. An der Z-Fahreinheit 66 ist das Handrad 70 zur Auswahl der Stempel-Meißel-Kombination, der Werkzeugkopf 90 zur Aufnahme des Heizkreuzes 62 und des Scherkreuzes 60 und das Sensorelement 92 mit dem integrierten Y-DMS angebracht.

Zum Austausch der Heiz-Scher-Einheit wird zunächst die zentrale Zylinderschraube 94a gelöst, um das Scherkreuz 60 abzunehmen, das gegenüber dem Heizkreuz 62 mit einem Federblech 96 angeordnet ist. Anschließend werden die Zylinderschrauben 94b gelöst und das Heizkreuz 62 kann von der schwimmenden Lagerung auf dem Werkzeugkopf 90 abgenommen werden. Jedes Schermeißelblatt 98 kann vom Meißelkreuz (60) abgenommen und durch entsprechende Drehung 8-fach neu eingespannt werden.

Gegenüber der dargestellten Ausführungsform der erfindungsgemäßen Vorrichtung zur Durchführung der reparaturmäßigen Entfernung von Bauelementen von einem Platinensubstrat sind die folgenden Modifikationen möglich.

Es.kann die in Fig. 1 dargestellte Gesamtanlage dahingehend erweitert werden, daß eine parallele Verarbeitung zur zeitgleichen Entfernung mehrerer Bauelemente erfolgt. Außerdem kann die Auswahl der Betriebsparameter an die Eigenschaften des konkret verwendeten Klebemittels oder an eine Anbringung des Bauelements mit einem Lötmittel angepaßt werden. Weiterhin ist es möglich, nicht den Heiz- und Scherkopf 12, sondern die Auflagetische mit entsprechenden X-rund Y-Vortrieben zu versehen. Außerdem können weitere Reinigungsmittel zur Entfernung von bei der Durchführung des erfindungsgemäßen Verfahrens anfallenden Material-Resten vorgesehen werden.

Die entscheidenden Vorteile der Erfindung sind darin zu sehen, daß der Aufheiz- und Abscherschritt automatisch mittels eines einheitlich positionierten Werkzeuges erfolgt, wobei ein hoher Schutz der übrigen Schaltungsbestandteile gegenüber versehentlicher Beschädigung durch die Auswahl der Betriebsparameter gegeben ist. Mit der erfindungsgemäßen Vorrichtung steigt die Erfolgsquote bei der Bauelemente-Entfernung erheblich, so daß die Kosten der Platinenreparatur stark gesenkt werden.

## Patentansprüche

1. Verfahren zur reparaturmäßigen Entfernung elektronischer Bauelemente von einem Platinensubstrat, insbesondere von integrierten Schaltkreisen, die mit einem Haftmittel auf dem Platinensubstrat angebracht sind, gekennzeichnet durch die Schritte:
- Substratvorbereitung zur Positionierung des Bauelementes in Bezug auf eine Werkzeugeinheit, die ein Heizmittel (62) und ein Schermittel (60) umfaßt,
- Aufsetzen der Heiz-Scher-Werkzeugeinheit auf das Bauelement, so daß das Heizmittel (62) auf dem Bauelement aufsitzt und das Schermittel (60) an einer Kante des Bauelements formschlüssig anliegt,
- selektive Aufheizung des Bauelementes mit dem Heizmittel (62) und
- Abscheren des Bauelements mit dem Schermittel (60).

2. Verfahren nach Anspruch 1, **dadurch gekennzeichnet, daß** die Substratvorbereitung umfaßt:
- eine Fixierung des Platinensubstrats auf einem temperierten Arbeitstisch (22) und
- eine Ausrichtung der Heiz-Scher-Einheit in Bezug auf das Platinensubstrat unter Verwendung einer optischen Überwachungs- und Einstellvorrichtung (26).

3. Verfahren nach Anspruch 1 und 2, **dadurch gekennzeichnet, daß** das Aufsetzen der Heiz-Scher-Einheit durch deren Einrichtung in einem Schnellgang mit anschließendem Aufsetzen des Heizmittels (72) auf das Bauelement in einem Kriechgang erfolgt, wobei das Aufsetzen unter einer Andruckkraft zur Ausbildung eines guten Wärmekontakts durchgeführt wird.

4. Verfahren nach einem der vorhergehenden Ansprüche, **dadurch gekennzeichnet, daß** die selektive Aufheizung durch die kontrollierte Erwärmung des Bauelementes mit dem Heizmittel (62) für eine kritische Zeit bei einer kritischen Temperatur erfolgt, wobei die Auswahl der kritischen Zeit und der kritischen Temperatur in Abhängigkeit von der Bauelemente- und Substratgröße zur Vermeidung von thermischen Beschädigungen erfolgt.

5. Verfahren nach einem der vorhergehenden Ansprüche, **dadurch gekennzeichnet, daß** die Erwärmung durch eine elektrische Impulsheizung erfolgt, wobei die kritische Zeit 3 s und die kritische Temperatur 270° C betragen.

6. Verfahren nach einem der vorhergehenden Ansprüche, **dadurch gekennzeichnet, daß** das Abscheren die folgenden Schritte umfaßt,
- Beaufschlagung des Schermittels mit einer definierten Scherkraft unter gleichzeitigem Verschiebeweg - und Scherkraftmessung und
- Beendigung des Schervorgangs, sobald ein Verschiebungs- und/oder Kraftkriterium erfüllt ist.

7. Verfahren nach Anspruch 6, **dadurch gekennzeichnet**, daß der Schervorgang abgebrochen wird, sobald die Werkzeugeinheit (60, 62) beim Abscheren einen Verschiebeweg von 1 mm überstrichen hat und/oder die von dem Schermittel (60) ausgeübte Scherkraft aufgrund der Ablösung des Bauelementes abfällt.

8. Verfahren nach Anspruch 6, **dadurch gekennzeichnet, daß** die ausgeübte Scherkraft maximal 650 N beträgt.

9. Verfahren nach einem der vorhergehenden Ansprüche, **dadurch gekennzeichnet, daß** vor der Substratvorbereitung eine Substrattemperierung zur Vermeidung von thermischen Verspannungen während des Aufheizens des Bauelements erfolgt.

10. Verfahren nach einem der vorhergehenden Ansprüche, **dadurch gekennzeichnet, daß** nach der Entfernung des Bauelementes eine manuelle Nachbearbeitung zum Abtrag von Haftmittelresten erfolgt.

11. Verfahren nach einem der vorhergehenden Ansprüche, **gekennzeichnet durch** eine Rechnersteuerung zur automatischen Durchführung des Aufsetzens der Heiz-Scher-Einheit, des Aufheizens und des Abscherens.

12. Verfahren nach einem der vorhergehenden Ansprüche, **dadurch gekennzeichnet, daß** die Heiz-Scher-Einheit nach Entfernen des Bauelementes gereinigt wird.

13. Vorrichtung zur reparaturmäßigen Entfernung elektronischer Bauelemente von einem Platinensubstrat, insbesondere von integrierten Schaltkreisen, die mit einem Haftmittel auf dem Platinensubstrat angebracht sind, **dadurch gekennzeichnet, daß** das zu entfernende Bauelement und eine Heiz-Scher-Einheit zueinander beweglich einstellbar sind, wobei die Heiz-Scher-Einheit mindestens ein Heizmittel (62) zum selektiven Aufheizen des Bauelementes und mindestens ein Schermittel (60) zum mechanischen Abscheren des Bauelementes umfaßt, und wobei die Betriebstemperatur des Heizmittels (62) und die Scherkraft des Schermittels (60) von einer Steuereinheit (40) steuerbar sind.

14. Vorrichtung nach Anspruch 13, **gekennzeichnet durch** einen Heiz-Scher-Kopf (12), an dem die Heiz-Scher-Einheit und das Einstellmittel angebracht sind und der in einer Ebene parallel zu einem Arbeitstisch (22) beweglich ist.

15. Vorrichtung nach Anspruch 13 und 14, **dadurch gekennzeichnet, daß** die Heiz-Scher-Einheit durch ein Drehkreuz gebildet wird, dessen Arme jeweils Heizstempel (62a - 62d) und einen an diesen angrenzenden Schermeißel (60) tragen.

16. Vorrichtung nach einem Ansprüche 13 - 15, **dadurch gekennzeichnet, daß** das Einstellmittel durch eine Positionierungskamera (26) gebildet wird, deren Beobachtungsfeld von einem Monitor (42) der Steuereinheit (40) dargestellt wird.

17. Vorrichtung nach einem der Ansprüche 13 - 16, **dadurch gekennzeichnet, daß** die Heizstempel (62) mit einer Impulsheizung betrieben werden.

18. Vorrichtung nach einem der Ansprüche 13 - 17, **dadurch gekennzeichnet, daß** der Heizstempel (62) zum selektiven Aufheizen für die Dauer von 3 s eine Temperatur von 270° C besitzt.

19. Vorrichtung nach einem der Anspprüche 13 - 18, **dadurch gekennzeichnet, daß** die Scherkraft des Schermeißels (60) maximal 650 N beträgt.

## Claims

1. Method of removing electronic components for repair purposes from a circuit board substrate, particularly from integrated switching circuits which are attached to the circuit board substrate with an adhesive, characterised by the steps of:
preparing the substrate to position the component with respect to a tool unit which includes heating means (62) and shearing means (60),
positioning the heating-shearing tool unit on the component so that the heating means (62) rests on the component and the shearing means (60) form lockingly engages an edge of the component,
selectively heating the component with the heating means (62) and shearing offthe component with the shearing means (60).

2. Method as claimed in claim 1, characterised in that the preparation of the substrate includes:
fixing the circuit board substrate onto a tempered working table (22) and aligning the heating-shearing unit with respect to the circuit board substrate using an optical monitoring and adjustment device (26).

3. Method as claimed in claims 1 and 2, characterised in that the positioning of the heating-shearing unit on the component is effected by setting it at high speed with subsequent positioning of the heating means (62) at low speed, the positioning being performed under a pressure to form a good thermal contact.

4. Method as claimed in one of the preceding claims, characterised in that the selective heating is effected by the controlled warming of the component with the heating means (62) for a critical time at a critical temperature, the selection of the critical time and of the critical temperature being effected in dependence on the size of the component and the substrate in order to prevent thermal damage.

5. Method as claimed in one of the preceding claims, characterised in that the warming is effected by an electrical impulse heater, the critical time being 3s and the critical temperature 270°C.

6. Method as claimed in one of the preceding claims, characterised in that the shearing off process includes the following steps,
applying a predetermined shearing force to the shearing means whilst simultaneously measuring the distance moved and the shearing force and
terminating the shearing process as soon as a distance and/or force criterion is fulfilled.

7. Method as claimed in claim 6, characterised in that the shearing process is interrupted as soon as the tool unit (60,62) has moved a distance of lmm whilst shearing and/or the shearing force exerted by the shearing means (60) decreases as a result of the separation of the component.

8. Method as claimed in claim 6, characterised in that the exerted shearing force is at most 650N.

9. Method as claimed in one of the preceding claims, characterised in that before the preparation of the substrate tempering of the substrate is effected to prevent thermal stresses during the heating of the component.

10. Method as claimed in one of the preceding claims, characterised in that after the removal of the component a subsequent manual processing is effected to remove adhesive residues.

11. Method as claimed in one of the preceding claims, characterised by a computer controller for automatically carrying out the positioning of the heating-shearing unit, the heating process and the shearing off process.

12. Method as claimed in one of the preceding claims, characterised in that the heating-shearing unit is cleaned after removal of the component.

13. Apparatus for removing electronic components from a circuit board substrate for repair purposes, in particular from integrated switching circuits, which are connected to the circuit board substrate with an adhesive, characterised in that the component to be removed and a heating-shearing unit are movably adjustable with respect to one another, the heating-shearing unit including at least one heating means (62) for selectively heating the component and at least one shearing means (60) for mechanically shearing off the component, the operating temperature of the heating means (62) and the shearing force of the shearing means (60) being controllable by a control unit (40).

14. Apparatus as claimed in claim 13, characterised by a heating-shearing head (12) on which the heating-shearing unit and the adjusting means are mounted and which is movable in a plane parallel to a working table (22).

15. Apparatus as claimed in claims 13 and 14. characterised in that the heating-shearing unit is constituted by a capstan, the arms of which carry a respective heating die (62a-62d) and a shearing chisel (60) adjoining it.

16. Apparatus as claimed in one of claims 13 - 15, characterised in that the adjustment means is constituted by a positioning camera (26), the field of view of which is displayed by a monitor (42) of the control unit (40).

17. Apparatus as claimed in one of claims 13 - 16, characterised in that the heating dies (62) are operated with an impulse heater.

18. Apparatus as claimed in one of claims 13 - 17, characterised in that the heating die (62) for selectively heating for the period of 3s has a temperature of 270°C.

19. Apparatus as claimed in one of claims 13 - 18, characterised in that the shearing force of the shearing chisel (60) is at most 650N.

## Revendications

1. Procédé pour enlever, à des fins de réparation, des éléments modulaires électroniques à partir d'un substrat de platine, en particulier des circuits intégrés qui ont été appliqués sur le substrat de platine au moyen d'un produit adhésif, procédé caractérisé par les étapes suivantes :
- préparation du substrat pour le positionnement de l'élément modulaire par rapport à un ensemble d'outil qui comporte un moyen de chauffage (62) et un moyen de coupe (60),
- application de l'ensemble chauffage-coupe sur l'élément modulaire afin que le moyen de chauffage (62) repose sur l'élément modulaire et que le moyen de coupe (60) se trouve appliqué en engagement positif sur une tranche ou arête de l'élément modulaire,
- montée en température sélective de l'élément modulaire avec le moyen de chauffage (62), et
- séparation par coupe de l'élément modulaire à l'aide du moyen de coupe (60).

2. Procédé selon la revendication 1, caractérisé en ce que la préparation du substrat comprend :
- la fixation du substrat de platine sur une table de travail équilibrée en température (22), et
- l'alignement de l'ensemble chauffage-coupe par rapport au substrat de platine en utilisant un dispositif de réglage ou ajustement et de surveillance optique (26).

3. Procédé selon les revendications 1 et 2, caractérisé en ce que l'application de l'ensemble de chauffage-coupe s'effectue par sa mise en place dans une opération rapide avec l'application consécutive du moyen de chauffage (62) sur l'élément modulaire dans un procédé de fluage, l'application s'effectuant sous l'effet d'une force de compression pour assurer un bon contact thermique.

4. Procédé selon l'une des revendications précédentes, caractérisé en ce que la montée en température sélective s'effectue par la montée en température contrôlée de l'élément modulaire à l'aide du moyen de chauffage (62) pendant une durée critique à une température critique, la sélection de la durée critique et de la température critique s'effectuant en fonction de la taille de l'élément modulaire et du substrat afin d'éviter des détériorations thermiques.

5. Procédé selon l'une des revendications précédentes, caractérisé en ce que la montée en température s'effectue au moyen d'un chauffage électrique par impulsions, la durée critique étant de 3 secondes et la température critique de 270°C.

6. Procédé selon l'une des revendications précédentes, caractérisé en ce que la séparation par coupe comprend les étapes suivantes
- mise en oeuvre du moyen de coupe à une force de cisaillement définie avec mesure simultanée de la force de cisaillement et de la distance de déplacement, et
- l'arrêt de l'opération de coupe dès qu'un critère de déplacement et/ou de force est rempli.

7. Procédé selon la revendication 6, caractérisé en ce que l'opération de coupe est interrompue dès que l'ensemble d'outil (60, 62), lors de la coupe de séparation a dépassé une distance de déplacement de 1 mm et/ou lorsque la force de cisaillement exercée par le moyen de coupe (60) chute par suite de la séparation de l'élément modulaire.

8. Procédé selon la revendication 6, caractérisé en ce que la force de cisaillement exercée atteint 650 N maximum.

9. Procédé selon l'une des revendications précédentes, caractérisé en ce qu'avant la préparation du substrat, s'effectue un équilibrage de température du substrat pour éviter les contraintes thermiques pendant le chauffage de l'élément modulaire.

10. Procédé selon l'une des revendications précédentes, caractérisé en ce qu'après l'enlèvement ou séparation de l'élément modulaire, s'effectue un traitement manuel ultérieur pour évacuer les résidus du produit adhésif.

11. Procédé selon l'une des revendications précédentes, caractérisé par la commande par ordinateur en vue de l'exécution automatique de l'application de l'ensemble de chauffage-coupe, de la montée en température et de la séparation par coupe.

12. Procédé selon l'une des revendications précédentes, caractérisé en ce que l'ensemble de chauffage-coupe est nettoyée après enlèvement de l'élément modulaire.

13. Dispositif pour enlever, à des fins de réparation, des éléments modulaires électroniques à partir d'un substrat de platine, en particulier de circuits intégrés qui ont été appliqués sur le substrat de platine au moyen d'un produit adhésif, caractérisé en ce que l'élément modulaire à enlever et l'ensemble de chauffage-coupe sont réglables ou ajustables de facon mobile l'un par rapport à l'autre, l'ensemble de chauffage-coupe comportant au moins un moyen de chauffage (62) pour la montée en température sélective de l'élément modulaire et au moins un moyen de coupe (60) pour la séparation par coupe mécanique de l'élément modulaire, et la température de service de l'élément de chauffage (62) ainsi que la force de cisaillement du moyen de coupe (60) pouvant être régulées par un appareil de commande (40).

14. Dispositif selon la revendication 13, caractérisé par une tête de chauffage-coupe (12) sur laquelle sont montés l'ensemble de coupe-chauffage et l'ensemble de réglage, tête qui est mobile dans un plan parallèle à la table de travail (22).

15. Dispositif selon les revendications 13 et 14, caractérisé en ce que l'ensemble de chauffage-coupe est constitué par un tourniquet dont les bras portent respectivement un poinçon de chauffage (62a - 62d) et un ciseau de coupe (60) contigu à celui-ci.

16. Dispositif selon l'une des revendications 13-15, caractérisé en ce que le moyen de réglage est constitué par une caméra de positionnement (26) dont le champ d'observation est constitué par un moniteur (42) de l'appareil de commande (40).

17. Dispositif selon l'une des revendications 13-16, caractérisé en ce que les poinçons de chauffage (62) fonctionnent avec un chauffage par impulsions.

18. Dispositif selon l'une des revendications 13-17, caractérisé en ce que pour la montée en température sélective pendant une durée de 3 secondes, les poinçons de chauffage (62) ont une température de 270°C.

19. Dispositif selon l'une des revendications 13-18, caractérisé en ce que la force de cisaillement du ciseau de coupe (60) est au maximum de 650 N.
